(19) Europäisches Patentamt
European Patent Office
Office européen des brevets

(11)  EP 1 527 324 B1

(12)  **EUROPÄISCHE PATENTSCHRIFT**

(45) Veröffentlichungstag und Bekanntmachung des Hinweises auf die Patenterteilung:
**09.11.2011  Patentblatt 2011/45**

(21) Anmeldenummer: **03738423.7**

(22) Anmeldetag: **19.06.2003**

(51) Int Cl.:
**G01D 5/16** (2006.01)          **G01R 33/09** (2006.01)

(86) Internationale Anmeldenummer:
**PCT/IB2003/002901**

(87) Internationale Veröffentlichungsnummer:
**WO 2004/003478 (08.01.2004 Gazette 2004/02)**

(54)  **MAGNETORESISTIVER SENSOR**

MAGNETORESISTIVE SENSOR

CAPTEUR MAGNETORESISTIF

(84) Benannte Vertragsstaaten:
**AT BE BG CH CY CZ DE DK EE ES FI FR GB GR HU IE IT LI LU MC NL PT RO SE SI SK TR**

(30) Priorität: **27.06.2002  DE 10228662**

(43) Veröffentlichungstag der Anmeldung:
**04.05.2005  Patentblatt 2005/18**

(73) Patentinhaber: **NXP B.V.**
**5656 AG Eindhoven (NL)**

(72) Erfinder:
• **HINZ, M.;**
**c/o Philips Int. Pty. & Standards Gmbh**
**52066 Aachen (DE)**

• **BUTZMANN, S.;**
**c/o Philips Int. Pty. & Standadrs**
**52066 Aachen (DE)**

(74) Vertreter: **Krott, Michel et al**
**NXP Semiconductors**
**IP & Licensing Department**
**High Tech Campus**
**5656 AE Eindhoven (NL)**

(56) Entgegenhaltungen:
**EP-A- 0 484 859     EP-A- 0 863 406**
**DE-A- 10 137 294**

## Beschreibung

Die Erfindung betrifft einen magnetoresistiven Sensor zum Betrieb mit einem magnetisierten Encoder, der eine Zone mit abwechselnd entlang einer Bewegungsrichtung angeordneten magnetischen Nord- und Südpolen aufweist, umfassend eine Wheatstonesche Brückenanordnung mit einem ersten Brückenzweig zwischen einem ersten Speiseanschluß und einem ersten Signalausgangsanschluß der Wheatstoneschen Brückenanordnung, einem zweiten Brückenzweig zwischen dem ersten Speiseanschluß und einem zweiten Signalausgangsanschluß der Wheatstoneschen Brückenanordnung, einem dritten Brückenzweig zwischen einem zweiten Speiseanschluß und dem ersten Signalausgangsanschluß der Wheatstoneschen Brückenanordnung sowie einem vierten Brückenzweig zwischen dem zweiten Speiseanschluß und dem zweiten Signalausgangsanschluß der Wheatstoneschen Brückenanordnung, worin jeder der Brückenzweige ein ohmsches Widerstandselement mit einer Abhängigkeit des Widerstandswertes von der magnetischen Feldstärke eines auf das ohmsche Widerstandselement einwirkenden magnetischen Feldes gemäß einer vorgegebenen Kennlinie umfaßt. Die Erfindung betrifft ferner eine Bewegungs- und/oder Geschwindigkeitsmeßeinrichtung mit einem genannten magnetisierten Encoder. Derartige Sensoren und Bewegungs- und/oder Geschwindigkeitsmeßeinrichtung sind bevorzugt im Automobilbau für die Positionsmessung, Drehzahlmessung und Drehrichtungserkennung von bewegten Fahrwerks- und Motorteilen vorgesehen.

Ein Sensor der eingangs genannten Art ist aus der WO 00/29815 bekannt. Bei diesem Sensor sind die ohmschen Widerstandselemente des ersten und des vierten Brückenzweigs einerseits und diejenigen des zweiten und des dritten Brückenzweigs andererseits je ineinander verschachtelt angeordnet. Die ohmschen Widerstandselemente der vier Brückenzweige sind im übrigen identisch ausgeführt, d.h. weisen übereinstimmende Widerstandswerte auf. Die beiden verschachtelten, als "Felder" bezeichneten Anordnungen sind in einem räumlichen Abstand voneinander angebracht, der an wenigstens nahezu die Hälfte einer der Polflächen eines Ringmagneten angepaßt ist. Ein derartiger Ringmagnet wird gemäß WO 00/29815 typischerweise für die Geschwindigkeitsmessung von Kfz-Rädern benutzt. Der Abstand der "Felder" ist demgemäß derart bemessen, daß eines der "Felder" sich gerade über der Mitte einer der Polflächen des Ringmagneten befindet, wenn die andere der Polflächen sich über einer Grenze zwischen zwei benachbarten Polflächen befindet. Da diese Anordnung an der Wheatstoneschen Brückenanordnung ein Ausgangssignal hervorruft, welches für jede der Polflächen einen Wellenberg und ein Wellental aufweist, wird vom Sensor für jede der Polflächen ein Ausgangsimpuls bzw. eine Impulsperiode abgegeben. Gegenüber nach WO 00/29815 als herkömmlich bezeichneten Sensoren mit je einem Ausgangssignalimpuls für jedes überstrichene Polpaar kann somit der Ringmagnet auf die Hälfte verkleinert werden, wobei eine unveränderte Anzahl von Ausgangssignalimpulsen erhalten wird.

Bei einem unveränderten Ringmagneten wird daher eine Verdoppelung der Anzahl der Ausgangssignalimpulse, d.h. eine Frequenzverdoppelung des Ausgangssignals der Wheatstoneschen Brückenanordnung, erreicht.

Weitere magnetoresistive Sensoren mit einer Wheatstoneschen Brückenanordnung der Widerstandselemente sind aus EP-A-0 484 859, EP -A-0 863 406 und DE-A-10 137 294 bekannt.

Die Erfindung hat die Aufgabe, einen magnetoresistiven Sensor zum Betrieb mit einem magnetisierten Encoder unter weiterer Verringerung der räumlichen Abmessungen zu schaffen.

Erfindungsgemäß wird diese Aufgabe durch einen magnetoresistiven Sensor der im Anspruchs 1 genannten Art gelöst.

Ein derart aufgebauter Sensor ist sehr kompakt und ermöglicht unter Beibehaltung der Frequenzverdoppelung des Ausgangssignals der Wheatstoneschen Brückenanordnung eine weitere Verringerung der Abmessungen einer damit ausgestatteten Bewegungs- und/oder Geschwindigkeitsmeßeinrichtung.

Die durch eine in der Zukunft angestrebte Verkleinerung der mechanischen Komponenten im Automobilbereich (z.B. Radlager) und der damit verbundenen Einschränkung der Platzverhältnisse bestehende Anforderung, die Auflösung des Ausgangssignals von Bewegungs- und/oder Geschwindigkeitsmeßeinrichtungen beizubehalten bzw. zu verbessern, wird durch Anwendung der Frequenzverdopplung bereits im magnetoresistiven Sensor erfüllt. Mit Hilfe der Erfindung können Positionen und Drehzahlen ermittelt werden, wobei die Frequenz des Ausgangssignals des Sensors gegenüber herkömmlichen Sensoren ohne Verwendung zusätzlicher elektronischer Komponenten verdoppelt ist.

An dieser Stelle sei bemerkt, daß aus der DE 33 17 594 A1 ein Magnetfeldsensor bekannt ist, der aus zwei in Reihe geschalteten Sensorelementen besteht, die mit zwei Widerstandselementen eine Wheatstonesche Brückenschaltung bilden. Die Sensorelemente weisen parallel liegende Strompfade aus magnetoresistivem Material auf, die ohne Einwirkung eines Magnetfeldes in derselben Richtung magnetisiert sind. Bei Einwirkung eines Magnetfeldes ändern sich die ohmschen Widerstandswerte der Sensorelemente gleichsinnig, so daß die im Nullzweig der Wheatstoneschen Brücke gemessene Spannung ein Maß für den Betrag des Magnetfeldgradienten ist.

Ferner sei bemerkt, daß aus der DE-OS 29 11 733 ein Magnetfeldsensor bekannt ist, der zwei Sensorelemente mit aus magnetoresistivem Material bestehenden Hauptstromleitpfaden aufweist, die zueinander senkrecht angeordnet sind, und die mit Vormagnetisierungsfeldern gespeist werden, welche sich zueinander in derselben Richtung und unter einem Winkel von 45° in Bezug auf jeden Hauptstromleitpfad erstrecken. Die in Reihe geschalteten Sensorelemente bilden mit zwei magnetfeldunabhängigen ohmschen Widerstandselementen eine Wheatstonesche Brückenschaltung.

Eine in deren Nullzweig gemessene Ausgangsspannung ist abhängig von einer Winkelverschiebung des Vormagnetisierungsfeldes oder der Hauptstromleitpfade. Daher wird gemäß der Lehre dieser Schrift eine Anordnung der Sensorelemente mit einander parallelen Hauptstromleitpfaden, aber zueinander entgegengesetzten Vormagnetisierungsfeldern empfohlen, wobei insbesondere die Sensorelemente im Abstand voneinander angeordnet sind.

Beispielsweise ist bei einem magnetoresistiven Sensors vorgesehen, daß die Widerstandswerte der ohmschen Widerstandselemente in zwei Brückenzweigen mit untereinander zumindest im wesentlichen übereinstimmend gewählten Kennlinien zumindest im wesentlichen konstant über der magnetischen Feldstärke des auf die ohmschen Widerstandselemente einwirkenden magnetischen Feldes sind. Damit wird die Wheatstonesche Brückenanordnung mit zwei magnetfeldbeeinflußten und zwei magnetfeldunabhängigen Brückenzweigen gebildet. Die magnetfeldunabhängigen Brückenzweige können bevorzugt mit Festwiderständen ausgeführt sein.

Weiterhin sind die ohmschen Widerstandselemente mit über der magnetischen Feldstärke des auf die ohmschen Widerstandselemente einwirkenden magnetischen Feldes zumindest im wesentlichen konstanten Widerstandswerten mit einer magnetischen Abschirmung ausgebildet. Alle Widerstandselemente können dann im selben Herstellungsschritt mit wenigstens nahezu identischer Bemessung gestaltet werden, wodurch sich eine einfache und genaue Herstellung ergibt. Die Widerstandselemente, die zumindest im wesentlichen konstante Widerstandswerte aufweisen sollen, werden zusätzlich magnetisch geschirmt, damit ein auf den Sensor einwirkendes Magnetfeld keinenEinfluß auf diese Widerstandselemente ausüben kann.

Bevorzugt ist der erfindungsgemäße Sensor in einer Bewegungs- und/oder Geschwindigkeitsmeßeinrichtung mit einem magnetisierten Encoder, der eine Zone mit abwechselnd entlang einer Bewegungsrichtung angeordneten magnetischen Nord- und Südpolen aufweist, einsetzbar. Diese Bewegungs- und/oder Geschwindigkeitsmeßeinrichtung weist vorteilhaft eine Frequenzauswerteeinrichtung auf, die an einem Eingang mit den Signalausgangsanschlüssen der Wheatstoneschen Brückenanordnung gekoppelt ist und an einem Ausgang ein Signal abgibt, welches ein Maß für die Frequenz eines vom magnetoresistiven Sensor abgegebenen Signals bildet.

Ausführungsbeispiele der Erfindung sind in der Zeichnung dargestellt und werden im Nachfolgenden näher erläutert. Es zeigen

Fig. 1 das Prinzipschaltbild eines Beispiels für einen erfindungsgemäßen magnetoresistiven Sensor in Wheatstonescher Brückenanordnung,

Fig. 2 Kennlinien der ohmschen Widerstandselemente eines magnetoresitiven Sensors als Darstellung der Abhängigkeit des Widerstandswertes der ohmschen Widerstandselemente von der magnetischen Feldstärke eines auf die ohmschen Widerstandselemente einwirkenden magnetischen Feldes,

Fig. 3 Kennlinien der ohmschen Widerstandselemente eines Ausführungsbeispiels des erfindungsgemäßen magnetoresistiven Sensors als Darstellung der Abhängigkeit des Widerstandswertes der ohmschen Widerstandselemente von der magnetischen Feldstärke eines auf die ohmschen Widerstandselemente einwirkenden magnetischen Feldes,

Fig. 4 eine Ausgangskennlinie der Wheatstoneschen Brückenanordnung eines Ausführungsbeispiels des erfindungsgemäßen magnetoresistiven Sensors als Funktion einer über den Signalausgangsanschlüssen der Wheatstoneschen Brückenanordnung gemessenen Ausgangsspannung in Abhängigkeit von der magnetischen Feldstärke eines auf die Wheatstonesche Brückenanordnung einwirkenden magnetischen Feldes,

Fig. 5 ein Beispiel für eine über den Signalausgangsanschlüssen der Wheatstoneschen Brückenanordnung gemessene Ausgangsspannung nach Vergleich mit einer Schaltschwelle,

Fig. 6 eine Ausbildung einer Bewegungs- und/oder Geschwindigkeitsmeßeinrichtung mit einem linearen magnetisierten Encoder als erstes Anwendungsbeispiel eines erfindungsgemäßen magnetoresistiven Sensors,

Fig. 7 eine Ausbildung einer Bewegungs- und/oder Geschwindigkeitsmeßeinrichtung mit einem rotationssymmetrischen magnetisierten Encoder als zweites Anwendungsbeispiel eines erfindungsgemäßen magnetoresistiven Sensors mit Anordnung des Sensors am Umfang des Encoders über dessen Mantelfläche, und

Fig. 8 eine Ausbildung einer Bewegungs- und/oder Geschwindigkeitsmeßeinrichtung mit einer Abwandlung eines rotationssymmetrischen magnetisierten Encoders als drittes Anwendungsbeispiel eines erfindungsgemäßen magnetoresistiven Sensors mit Anordnung des Sensors am Umfang des Encoders über dessen Stirnfläche.

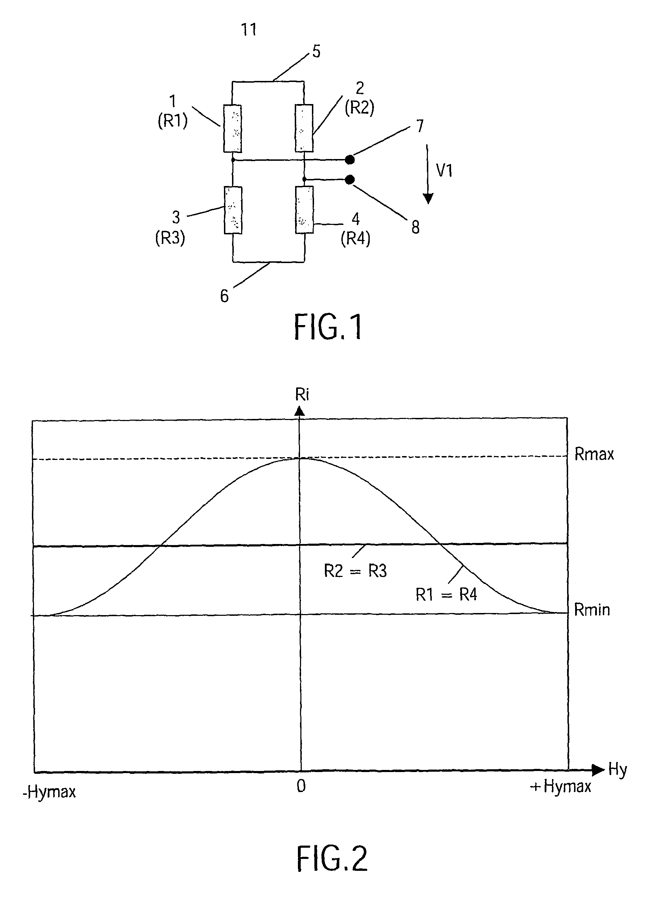

Magnetoresistive Sensoren, im folgenden der Einfachheit halber nur als "Sensoren" bezeichnet, sind bevorzugt aus wenigstens einer Wheatstoneschen Brückenanordnung gebildet, deren Brückenzweige mit Widerstandselementen ausgestaltet sind. Ein Beispiel für eine derartige Anordnung zeigt Fig. 1. In diesem mit dem Bezugszeichen 11 bezeichneten Sensor sind die einzelnen Widerstandselemente im ersten, zweiten, dritten bzw. vierten Brückenzweig mit den Bezugszeichen 1, 2, 3 bzw. 4 versehen. Die einzelnen Widerstandselemente werden vorzugsweise aus einem ferromagnetischen Material gefertigt, z.B. Permalloy, welches eine Verbindung u.a. aus Nickel und Eisen darstellt. Das Material wird vorteilhaft in Streifen ausgelegt, um durch die resultierende Streifenlänge einen definierten Widerstandswert Ri des einzelnen Widerstandselements i=1, 2, 3 bzw. 4 zu erreichen.

Die Wheatstonesche Brückenanordnung nach Fig. 1 weist weiterhin einen ersten und einen zweiten Speiseanschluß 5 bzw. 6 auf, an denen im Betrieb eine Speisepannung zugeführt wird. Das in der Darstellung der Fig. 1 mit dem Bezugszeichen V1 bezeichnete Ausgangssignal der Wheatstoneschen Brückenanordnung wird zwischen einem ersten und einem zweiten Signalausgangsanschluß 7 bzw. 8 abgegriffen.

Unter der Einwirkung eines äußeren - vom Sensor zu messenden - magnetischen Feldes mit der magnetischen Feldstärke H ändern die Widerstandselemente i ihre Widerstandswerte Ri, und das resultierende Ausgangssignal V1 der Wheatstoneschen Brückenanordnung ist eine Funktion dieser magnetischen Feldstärke H. Der Widerstandswert Ri eines derartigen Widerstandselements i ändert sich dabei insbesondere nach einer quadratischen Funktion. Aufgrund der quadratischen Abhängigkeit ist die Kennlinie zwischen dem Widerstandswert Ri eines derartigen Widerstandselements i und der magnetischen Feldstärke H abhängig vom Betrag, jedoch unabhängig vom Vorzeichen der Feldstärke H.

Für Anwendungen, bei denen keine lineare Kennlinie gefordert wird, können die magnetoresistiven Widerstandselemente mit nichtlinearer bzw. quadratischer Kennlinie eingesetzt werden. Hierzu gehört u.a. die Drehzahlmessung mit aktiven (z.B. magnetisierte Räder) oder passiven Encodern (z.B. ferromagnetische Zahnräder). Für z.B. eine Drehzahlmessung wird lediglich eine Erfassung z.B. der Nulldurchgänge des Ausgangssignals eines solchen Sensors benötigt, die relativ einfach mit einer dem Sensor nachgeschalteten Komparatoranordnung zu realisieren ist.

Bei aktiven Encodern (z.B. magnetisierten Polrädern) kann abhängig vom Abstand zwischen Sensor und Encoder der Betrag der magnetischen Feldstärke H gemessen werden, wobei der Abstand als Amplitudenhöhe des Ausgangssignals dargestellt wird. Die magnetisierten Encoder können z.B. eine lateral abwechselnd magnetisierte Schicht aufweisen (abwechselnde magnetische Nord-Südpole).

Bei einer relativen Bewegung des magnetisierten Encoders zu einem herkömmlichen Sensor ohne Frequenzverdoppelung wird ein periodisches Ausgangssignal erzeugt, welches bei einer Bewegung über ein Paar aus je einem zueinander benachbart angeordneten Nord- und Südpol der magnetisierten Schicht hinweg nur eine Signalperiode aufweist. Die Ausgangssignale können dabei unterschiedliche Signalformen annehmen, z.B. Dreieck, Rechteck, Sinus, usw., mit entsprechenden Nulldurchgängen. Ein Paar der genannten Art, als Polpaar bezeichnet, weist eine Polpaarbreite λ auf.

Für die Drehzahlmessung werden bei herkömmlichen Verfahren mit Drehzahlsensoren z.B. die Grenzen zwischen den magnetischen Nord- und Südpolen zur Nulldurchgangserkennung verwendet. Hierbei werden Signalverarbeitungsanordnungen mit einfachen Komparatorschaltungen eingesetzt, die aus den stetigen Ausgangssignalen der Sensoren binäre Signale erzeugen, die entsprechend von einer weiteren nachgeschalteten Auswerteeinheit bearbeitet werden können. Ein Anwendungsbeispiel ist die Drehzahlmessung für Bremssysteme im Automobil mit Antiblockiersystemen. Mit Hilfe einer Zählerschaltung kann bei bekannter Anzahl der magnetischen Nord- und Südpole auf dem eingesetzten Encoder die Drehzahl ermittelt werden. Bei den herkömmlichen Verfahren entspricht somit die Frequenz der genannten binären Signale der Anzahl der Polpaare des Encoders.

Für zukünftige Anwendungen magnetoresistiver Sensoren ist jedoch eine Erhöhung der Auflösung der Ausgangssignale der Sensoren über der Bewegungskoordinate des Encoders vorteilhaft. Insbesondere für den Einsatz von Encodern mit verringerten Abmessungen sowie für eine Erhöhung der Frequenz der Ausgangssignale ist es zu bevorzugen, wenn bereits der Sensor unmittelbar ein Ausgangssignal mit verdoppelter Frequenz zur Verfügung stellt. Dies gilt insbesondere für Anwendungsfälle mit erhöhter Anforderung an die Betriebssicherheit auch im Fehlerfall, z.B. im Automobilbereich.

Weiterhin soll ein Sensor bevorzugt universell für unterschiedliche Anwendungsfälle einsetzbar sein. Insbesondere soll vermieden werden, den Sensor in unterschiedlichen Anwendungsfällen an die jeweils eingesetzten Encoder baulich anpassen zu müssen.

Bei dem erfindungsgemäßen Sensor, der diese Anforderungen auf einfache Weise erfüllt und bevorzugt gemäß Fig. 1 mit einer Wheatstoneschen Brückenanordnung mit vier Brückenzweigen aufgebaut ist, bestimmt sich das Ausgangssignal VI gemäß der Gleichung

$$V1 = (R1/(R1+R3)) - (R2/(R2+R4)).$$

Werden in den vier Brückenzweigen vier Widerstandselemente mit der gleichen Abhängigkeit von der Feldstärke H eines in der Umgebung des Sensors wenigstens weitgehend homogenen äußeren Magnetfeldes eingesetzt, so ergeben sich durch den Einfluß dieses äußeren Magnetfeldes zwar Änderungen der einzelnen Widerstandswerte Ri; diese sind jedoch wenigstens nahezu identisch und bewirken somit keine Änderung des Ausgangssignals VI. Dieses Ausgangssignal VI ist somit keine Funktion der Feldstärke H.

Um eine unterschiedliche Änderung der Widerstandswerte Ri der einzelnen Widerstandselemente i = 1, 2, 3, 4 mit der Feldstärke zu erreichen, werden in zwei Brückenzweigen der Wheatstoneschen Brückenanordnung - z.B. im zweiten und im dritten Brückenzweig - Widerstandselemente 2, 3 mit konstantem Widerstandswert (R2=const.; R3=const.) - im folgenden auch als Festwiderstände bezeichnet - eingesetzt. Durch den Einfluß des äußeren magnetischen Feldes der Feldstärke H ergeben sich Widerstandsänderungen der magnetoresistiven Widerstandselemente 1, 4 in den beiden anderen Brückenzweigen, hier dem ersten und dem vierten, während die Festwiderstände ihren Wert beibehalten.

Fig. 2 zeigt beispielhafte Verläufe derartiger Kennlinien für die Änderung der Widerstandswerte Ri mit der Feldstärke Hy eines äußeren Feldes. Während die Festwiderstände 2, 3 ihre hier übereinstimmend gewählten Widerstandswerte R2 = R3 = const. über den gesamten Wertebereich der Feldstärke Hy von +Hymax bis -Hymax beibehalten, verändern sich die hier ebenfalls übereinstimmend gewählten Widerstandswerte R1 = R4 über dem genannten Wertebereich der Feldstärke Hy von +Hymax bis -Hymax zwischen den Grenzwerten Rmax bei Hy = 0 und Rmin bei Hy = +Hymax und Hy-Hymax. Vorzugsweise weist diese Kennlinie Ri(Hy) wenigstens in einem Wertebereich um Hy = 0 einen wenigstens nahezu quadratischen Verlauf auf.

Bei einer derartigen Wahl der Widerstandswerte Ri wird zwischen dem ersten und dem zweiten Signalausgangsanschluß 7 und 8 ein Ausgangssignal VI erhalten, welches ebenfalls eine nichtlineare Abhängigkeit von der Feldstärke Hy aufweist. Bei Einsatz eines in der beschriebenen Weise ausgelegten Sensors über einem magnetisierten Encoder wird ein Ausgangssignal V1 erzeugt, welches eine doppelte Frequenz gegenüber den vorstehend beschriebenen, herkömmlichen Drehzahlsensoren aufweist. Durch die Auswertung des Sensorsignals mit Hilfe einer einfachen Komparatorschaltung kann auch hier ein binäres Signal gewonnen werden.

Die Festwiderstände lassen sich in einfacher Weise mit Werkstoffen ausbilden, deren Widerscandseigenschaften magnetfeldunabhängig sind. In einer Abwandlung dieses Beispiels werden die Festwiderstände mit magnetoresistiven Widerstandselementen ausgebildet, die jedoch durch eine zusätzlich aufgebrachte magnetische Abschirmung der Einwirkung des äußeren Magnetfeldes entzogen sind. Hierbei ergibt sich ebenfalls eine Verdopplung der Ausgangssignalfrequenz gegenüber den beschriebenen herkömmlichen Sensoren.

Die Widerstandswerte Ri der Widerstandselemente i=1, 2 ,3, 4 sind von der Wahl der Werkstoffzusammensetzung und der räumlichen Gestaltung abhängig und können durch deren Veränderung eingestellt werden. Dies gilt auch für die erzielten Abhängigkeiten der Widerstandswerte Ri von der Feldstärke H. Zur Beschreibung der Werkstoffeigenschaften der Widerstandselemente i=1, 2 ,3, 4 wird eine als charakteristische Feldstärke H0 bezeichnete Materialkonstante herangezogen, die sich gemäß den nachstehenden Beziehungen zu

$$\text{H0} = \text{Hk} + \text{Hd, mit Hk} = 2*k/M \text{ und Hd} = -N*M$$

ergibt, wobei mit

- Hk die Anisotropiefeldstärke des Werkstoffs, die von dem einzusetzenden Material und den Herstellungsprozessen bestimmt wird,
- Hd die Demagnetisierungsfeldstärke Hd (auch Formanisotropie genannt), die von den geometrischen Ausdehnungen des Materials bestimmt wird,
- k eine Materialkonstante,
- N ein Demagnetisierungsfaktor und
- M eine interne Magnetisierung des Werkstoffes

bezeichnet ist.

In einem Ausführungsbeispiel des erfindungsgemäßen Sensors werden diese Eigenschaften dahingehend ausgenutzt, daß durch entsprechende Formung der durch Streifen des genannten Werkstoffs gebildeten Widerstandselemente - d.h. ihrer Höhe, Breite, usw. - für die einzelnen Widerstandselemente unterschiedliche charakteristische Feldstärken H0 und damit nichtlineare Kennlinien mit unterschiedlichen Verläufen erzeugt werden können.

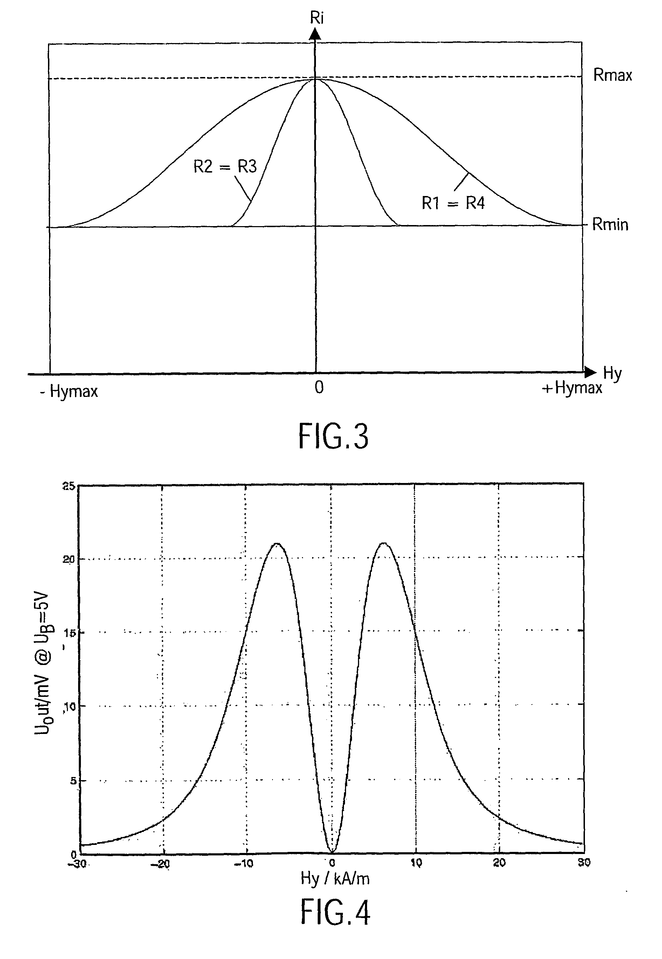

Ein Beispiel dafür ist in der Fig. 3 wiedergegeben, die im übrigen in ihrer Darstellung der Fig. 2 entspricht. Gegenüber dem in Fig. 2 dargestellten Beispiel sind die Widerstandswerte R1, R4 der Widerstandselemente 1 und 4 unverändert, wohingegen für die Widerstandselemente 2, 3 eine Abhängigkeit von der Feldstärke Hy in der dargestellten Art gewählt ist, in der die Widerstandswerte R2, R3 mit der Feldstärke Hy noch stärker variieren als die Widerstandswerte R1, R4.

Fig. 4 zeigt eine exemplarische Meßkurve für eine Ausgangskennlinie der Wheatstoneschen Brückenanordnung des durch Fig. 3 beschriebenen Ausführungsbeispiels als Funktion des über den Signalausgangsanschlüssen 7, 8 der Wheatstoneschen Brückenanordnung gemessenen Ausgangssignals VI in Abhängigkeit von der magnetischen Feldstärke Hy eines auf die Wheatstoneschen Brückenanordnung einwirkenden magnetischen Feldes. In der Darstellung dieses Diagramms ist jedoch das Ausgangssignal VI als Ausgangsspannung in mV aufgetragen und mit $U_o$ut benannt.

Die Maßeinheit für die Feldstärke Hy beträgt kA/m. Mit $U_B$ ist in Fig. 4 die im Betrieb zwischen dem ersten und dem zweiten Speiseanschluß 5 bzw. 6 der Wheatstoneschen Brückenanordnung angelegte Speisepannung benannt, die für die gezeigte Meßkurve einen Wert von 5V aufweist.

Eine vergleichbare Kurve erhält man auch für einen gemäß Fig. 2 dimensionierten Sensor.

Durchläuft bei einem äußeren Magnetfeld, welches auf einen durch eine Kennlinie der in Fig. 4 gezeigten Art beschriebenen Sensor wirkt, die Feldstärke Hy einen Zyklus z.B. von Hy = 0 über Hy = Hymax, Hy = 0, Hy = -Hymax zurück nach Hy = 0, ist anhand des Diagramms der Fig. 4 erkennbar, daß während dieses Durchlaufs das Ausgangssignal VI bzw. die Ausgangsspannung Uout zwei Zyklen seiner bzw. ihrer Variation zwischen dem niedrigsten und dem höchsten Wert durchläuft. An den Signalausgangsanschlüssen 7, 8 der Wheatstoneschen Brückenanordnung ergibt sich damit ein Ausgangssignal VI, welches im Vergleich zu der durch die Bewegung gegenüber den Polpaaren des Encoders hervorgerufenen Variation der Feldstärke Hy eine Verdopplung der Frequenz aufweist.

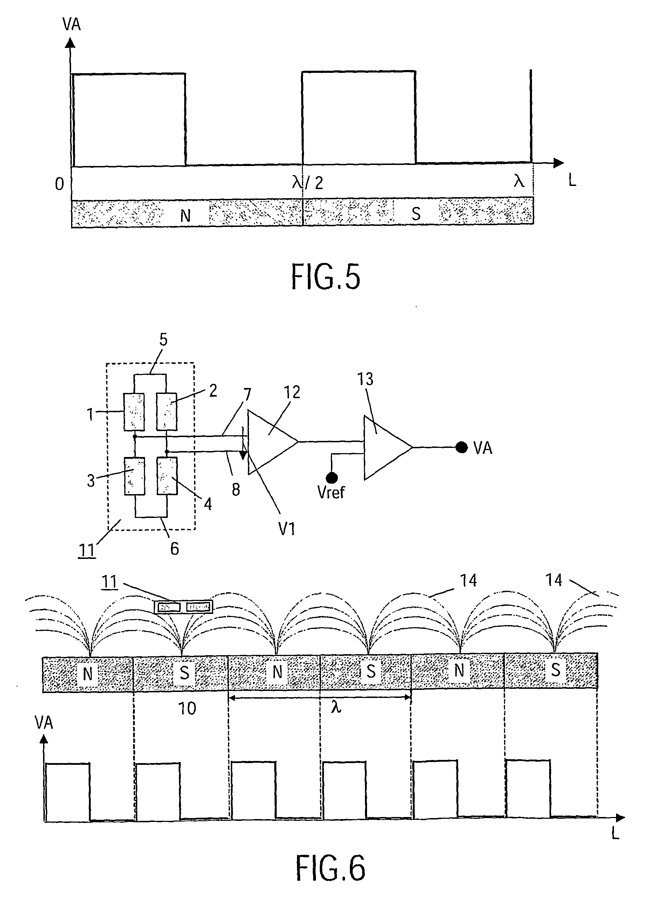

Fig. 5 zeigt einen beispielhaften Verlauf eines binären Signals VA, welches aus dem stetigen Verlauf des Ausgangssignals VI durch Vergleich mit einer Schaltschwelle Vref in an sich bekannter Weise gewonnen worden ist. Zum Vergleich ist unter dem binären Signal VA schematisch die Lage eines Polpaares N - S des Encoders skizziert und sind die Abmessungen der Pole N und S des Encoders entlang seiner Bewegungskoordinaten L mit Hilfe der Polpaarbreite 1 bzw. der halben Polpaarbreite 1 /2 eingetragen. Der Bewegung zwischen Sensor und Encoder entlang der Bewegungskoordinate L um eine Polpaarbreite 1 entsprechen zwei Perioden des binären Signals VA.

Die frequenzverdoppelnde Eigenschaft des erfindungsgemäßen magnetoresistiven Sensors fördert in vorteilhafter Weise den Einsatz in unterschiedlichsten Anwendungen zur Drehzahl- und Positionsmessung (Bewegungs- und/ oder Geschwindigkeitsmessung)mit magnetisierten Encodern. Die Encoder können hierbei z.B. als Linealmaßstab zur Linearwegmessung oder als Rad zur Drehzahlmessung eingesetzt werden. Dabei lassen sich die nachfolgend zu Fig. 6 bis 8 beschriebenen Anwendungsbeispiele mit unterschiedlichen Ausführungen des Encoders bei entsprechender weiterer Verarbeitung der Ausgangssignale auch zur Positionsbestimmung einsetzen.

Fig. 6 zeigt eine Ausbildung einer Bewegungs- und/oder Geschwindigkeitsmeßeinrichtung mit einem linearen magnetisierten Encoder 10 als erstes Anwendungsbeispiel eines erfindungsgemäßen magnetoresistiven Sensors 11. Darin sind bereits beschriebene Elemente wieder mit identischen Bezugszeichen versehen. Gemäß der im oberen Teil der Fig. 6 dargestellten Blockschaltbild ist der Sensor 11 über seine Signalausgangsanschlüsse 7 und 8 mit Eingangsanschlüssen eines Differenzverstärkers 12 verbunden, der zum Verstärken des vom Sensor 11 abgegebenen Ausgangssignals VI dient. Zum Weiterverarbeiten des verstärkten Ausgangssignals ist der Differenzverstärker 12 mit seinem Ausgangsanschluß an einen ersten Eingangsanschluß eines Komparators 13 angeschlossen, dem über einen zweiten Eingangsanschluß eine Spannung Vref zugeführt wird. Die Spannung Vref bildet eine Schaltschwelle, mit der der stetige Verlauf des (verstärkten) Ausgangssignals VI verglichen wird zum Gewinnen eines binären Signals VA am Ausgang des Komparators 13.

Im mittleren Teil der Fig. 6 ist schematisch die Anordnung der magnetischen Nordpole N und Südpole S des magnetisierten Encoders 10 wiedergegeben. Der Verlauf der magnetischen Feldlinien 14 zwischen den Polen N und S ist angedeutet. Jedes Polpaar aus einem Nord- und einem Südpol N, S weist - entlang der Bewegungskoordinate L des Encoders 10 gemessen - die Polpaarbreite λ auf. Der Sensor 11 ist mit seiner flächigen Ausdehnung planparallel zur Oberfläche des Encoders 10 ausgerichtet.

Im unteren Teil der Fig. 6 ist der Verlauf des binären Signals VA über der Bewegungskoordinate L des Encoders 10 aufgetragen, der demjenigen der Fig. 5 entspricht.

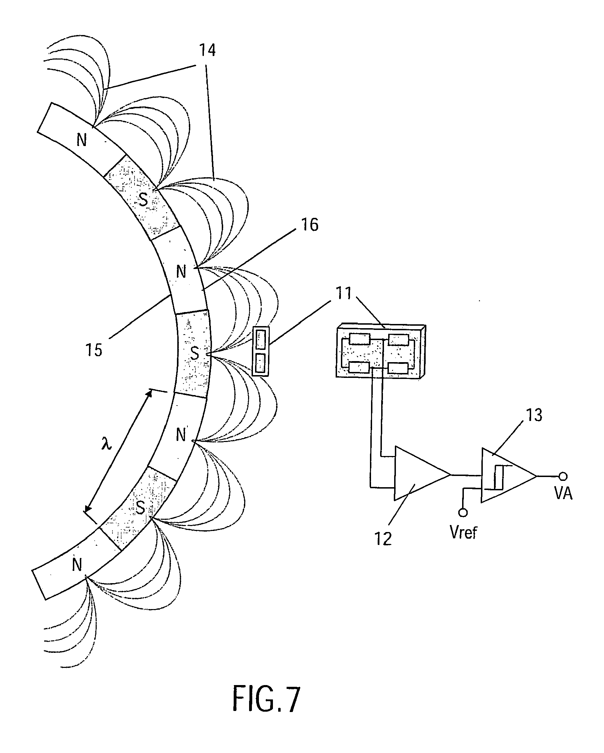

Fig. 7 zeigt eine Ausbildung einer Bewegungs- und/oder Geschwindigkeitsmeßeinrichtung mit einem rotationssymmetrischen magnetisierten Encoder 15 als zweites Anwendungsbeispiel eines erfindungsgemäßen magnetoresistiven Sensors 11 mit Anordnung des Sensors 11 am Umfang des Encoders 15 über dessen Mantelfläche 16. Auch hier ist der Sensor 11 mit seiner flächigen Ausdehnung planparallel zur Mantelfläche 16 des Encoders 15 ausgerichtet. Im übrigen entspricht die Anordnung derjenigen nach Fig. 6.

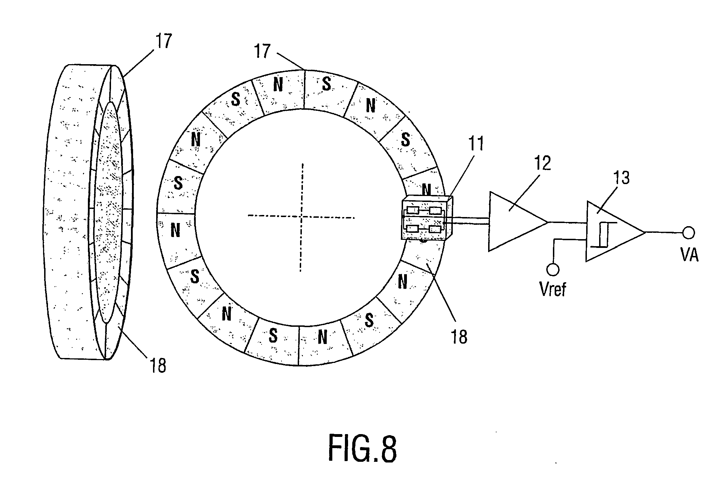

Fig. 8 zeigt eine Ausbildung einer Bewegungs- und/oder Geschwindigkeitsmeßeinrichtung mit einer Abwandlung eines rotationssymmetrischen magnetisierten Encoders 17 als drittes Anwendungsbeispiel eines erfindungsgemäßen magnetoresistiven Sensors 11 mit Anordnung des Sensors 11 am Umfang des Encoders 17 über dessen Stirnfläche 18. Der Sensor 11 ist mit seiner flächigen Ausdehnung planparallel zur Stirnfläche 18 des Encoders 17 ausgerichtet. Im übrigen entspricht die Anordnung denjenigen nach Fig. 6 und 7.

Der erfindungsgemäße Sensor sowie die erfindungsgemäße Bewegung- und/oder Geschwindigkeitsmeßeinrichtung sind gegenüber der in der WO 00/29815 gezeigten Anordnung kompakter und einfacher aufgebaut. Damit ist es vorteilhaft möglich, einer gewünschten Verringerung der Abmessungen von Bauteilen insbesondere im Automobilbereich, z.B. Verkleinerung der Radlager, und der damit einhergehend geforderten Gewichts- und Kosteneinsparung besser zu entsprechen.

Durch die Reduzierung der Abmessungen der genannten Bauteile im Automobilbereich ist es unumgänglich, die dort eingesetzten magnetisierten Encoder ebenfalls zu verkleinern. Die Verkleinerung des Encoders führt bei herkömmlichen Drehzahlsensoren dazu, daß sich bei ansonsten gleichbleibenden Eigenschaften des Encoders die magnetische Feldstärke des dem Sensor durch den Encoder aufgeprägten äußeren Feldes drastisch verringert. Folgen sind hierbei u.a. ein eingeschränkter nutzbarer Luftspaltbereich zwischen Encoder und Sensor bei gleicher Anzahl der Magnetpole. Werden, um den nutzbaren Luftspaltbereich beizubehalten, die magnetischen Eigenschaften der Magnetisierung des Encoders verbessert, z.B. durch ein stärkeres magnetisches Material, oder die geometrischen Verhältnisse verändert, z.B. durch eine Reduzierung der Anzahl der Magnetpole auf dem Encoder, erkauft man sich dies mit einer geringeren Auflösung des Ausgangssignals, die gerade bei niedrigen Geschwindigkeiten des Encoders zu Verschlechterungen der Meßergebnisse führen kann. Um dies zu vermeiden, empfiehlt es sich, eine frequenzverdoppelnde Sensoranordnung einzusetzen.

Neben dem Einsatz von dem Sensor nachgeschalteten Signalverarbeitungsstufen zur Erzeugung binärer Signale mit einer gegenüber der Frequenz des Ausgangssignals des Sensors erhöhten Frequenz und dem damit verbundenen Aufwand ist es einfacher und betriebssicherer, eine Frequenzverdoppelung innerhalb des Sensors auszuführen. Der magnetoresistive Sensor mit nichtlinearer Kennlinie ermöglicht es, gegenüber herkömmlichen Drehzahlsensoren die Frequenz des binären Signals zu verdoppeln. Weiterhin bietet der magnetoresistive Sensor mit nichtlinearer Kennlinie den Vorteil einer von den Abmessungen des jeweils verwendeten Encoders unabhängigen Anwendung, d.h. daß für magnetisierte Encoder mit unterschiedlichen Polpaarbreiten $\lambda$ lediglich eine Bauform des Sensors benötigt wird. Die Kosten für die Bereitstellung verschiedener Sensorbauformen für Encoder mit unterschiedlichen Polpaarbreiten entfallen somit.

Für Positionsmessungen an magnetisierten Encodern ergeben sich durch die Frequenzvervielfachung ebenfalls Vorteile. Hierzu gehört z.B. die Verringerung des Schaltungsaufwands für die elektronische Auswerteschaltung bei Anwendung von Interpolationsmethoden. Mit Hilfe der Frequenzverdopplung kann der Interpolationsfaktor reduziert werden. Dies bedeutet weniger Platzbedarf bezüglich des Aufwandes für die elektronischen Komponenten und eine wesentliche Kostenreduzierung.

Aufgrund der nichtlinearen bzw. insbesondere zumindest abschnittsweise quadratischen Kennlinie des Sensors besteht nicht die Gefahr des sogenannten "Flippens", d.h. der Kennlinienumkehr bei Richtungsänderung des äußeren Magnetfeldes, die bei linearisierten Kennlinien vorhanden sein kann. Um dieses "Flippen" durch äußere Magnetfelder zu verhindern, wird bei bekannten Anordnungen vorzugsweise ein Hilfsmagnet am Sensor angebracht. Bei dem erfindungsgemäßen Sensor wird ein solcher Hilfsmagnet nicht benötigt. Somit können Einbauraum und Kosten reduziert werden.

Gegenüber Sensoren mit orthogonaler Anordnung zum magnetisierten Encoder, wie sie z.B. bei Winkelsensoren üblich ist, bietet der erfindungsgemäße Sensor mit nichtlinearer Kennlinie den Vorteil der planparallelen Anordnung zur Oberfläche des magnetisierten Encoders. Hierdurch besteht die Möglichkeit, eine günstige Einbaulage des Sensors zum Encoder zu erreichen, in der die hohen magnetischen Feldstärken des Encoders ausgenutzt werden können.

## Patentansprüche

1. Magnetoresistiver Sensor (A1) zum Betrieb mit einem magnetisierten Encoder, der eine Zone mit abwechselnd entlang einer Bewegungsrichtung angeordneten magnetischen Nord-und Südpolen aufweist, umfassend eine Wheatstonesche Brückenanordnung mit einem ersten Brückenzweig zwischen einem ersten Speiseanschluss (5) und einem ersten Signalausgangsanscliluss (7) der Wheatstoneschen Brückenanordnung, einem zweiten Brückenzweig zwischen dem ersten Speiseanschluss (5) und einem zweiten Signalausgangsanschluss (8) der Wheatstoneschen Brückenanordnung, einem dritten Brückenzweig zwischen einem zweiten Speiseanschluss (6) und dem ersten Signalausgangsanschluss (7) der Wheatstoneschen Brückenanordnung sowie einem vierten Brückenzweig zwischen dem zweiten Speiseanschluss (6) und dem zweiten Signalausgangsanschluss (8) der Wheatstoneschen Brückenanordnung, worin jeder der Brückenzweige ein ohmsches Widerstandselement mit einer Abhängigkeit des Widerstandswertes von der magnetischen Feldstärke eines auf das ohmsche Widerstandselement einwirkenden magnetischen Feldes gemäß einer vorgegebenen Kennlinie umfasst, wobei sich die Widerstandswerte von jedem der ohmschen Widerstandselemente in Abhängigkeit von der magnetischen Feldstärke des auf die ohmschen Widerstandselemente einwirkenden magnetischen Feldes gleichsinnig ändern,

    wobei die Kennlinien der ohmschen Widerstandselemente im ersten und vierten Brückenzweig (1, 4) untereinander zumindest im wesentlichen übereinstimmend und deutlich verschieden von den untereinander zumindest im wesentlichen übereinstimmend gewählten Kennlinien der ohmschen Widerstandselemente im zweiten und dritten Brückenzweig (2, 3) gewählt sind.

2. Magnetoresistiver Sensor nach Anspruch 1,
    wobei die Widerstandswerte von jedem ohmschen Widerstandselement denselben Maximalwert aufweisen.

3. Magnetoresistiver Sensor nach Anspruch 1,

wobei die Widerstandswerte der Widerstandselemente im zweiten und dritten Brückenzweig (R2, R3) in Abhängigkeit von der Feldstärke stärker variieren als die Widerstandswerte der Widerstandselemente im ersten und vierten Brückenzweig (R1, R4).

**4.** Bewegungs-und/oder Geschwindigkeitsmesseinrichtung mit einem magnetisierten Encoder, der eine Zone mit abwechselnd entlang einer Bewegungsrichtung angeordneten magnetischen Nord-und Südpolen aufweist, **gekennzeichnet durch** einen magnetoresistiven Sensor nach einem der Ansprüche 1 bis 3.

**5.** Bewegungs-und/oder Geschwindigkeitsmesseinrichtung nach Anspruch 4, **gekennzeichnet durch** eine Frequenzauswerteeinrichtung, die an einem Eingang mit den Signalausgangsanschlüssen der Wheatstoneschen Brückenanordnung gekoppelt ist und an einem Ausgang ein Signal abgibt, welches ein Mass für die Frequenz eines vom magnetoresistiven Sensor abgegebenen Signals bildet.

## Claims

**1.** A magnetoresistive sensor for operation with a magnetized encoder, which comprises a zone with magnetic north and south poles arranged alternately along a direction of motion, comprising a Wheatstone bridge configuration with a first bridge arm between a first supply terminal (5) and a first signal output terminal (7) of the Wheatstone bridge configuration, a second bridge arm between the first supply terminal (5) and a second signal output terminal (8) of the Wheatstone bridge configuration, a third bridge arm between a second supply terminal (6) and the first signal output terminal (7) of the Wheatstone bridge configuration, as well as a fourth bridge arm between the second supply terminal (6) and the second signal output terminal (8) of the Wheatstone bridge configuration, wherein each of the bridge arms comprises an ohmic resistance element with a resistance-value dependence on the magnetic field strength of a magnetic field influencing the ohmic resistance element in accordance with a defined characteristic, wherein the resistance-values of each of the ohmic resistance elements vary in the same direction depending on the magnetic field strength of the magnetic field influencing the ohmic resistance elements, wherein the characteristics of the ohmic resistance elements in the first and fourth bridge arms (1, 4) are selected to be at least essentially matching with each other and significantly different from the characteristics, selected to be at least essentially matching with each other, of the ohmic resistance elements in the second and third bridge arms (2, 3).

**2.** A magnetoresistive sensor according to claim 1, wherein the resistance values of each ohmic resistance element have the same maximum value.

**3.** A magnetoresistive sensor according to claim 1, wherein the resistance values of the resistance elements in the second and third bridge arms (R2, R3) vary more strongly depending on the magnetic field strength than the resistance values of the resistance elements in the first and fourth bridge arms (R1, R4).

**4.** A motion and/or speed measurement device with a magnetized encoder which comprises a zone with magnetic north and south poles arranged alternately along a direction of motion, **characterized by** a magnetoresistive sensor according to one of the claims 1 to 3.

**5.** A motion and/or speed measurement device according to claim 4, **characterized by** a frequency evaluation device, which is coupled at one input with the signal output terminals of the Wheatstone bridge configuration and emits a signal at one output, which forms a measure of the frequency of a signal emitted by the magnetoresistive sensor.

## Revendications

**1.** Capteur magnétorésistif (A1) pour le fonctionnement avec un codeur magnétisé, lequel présente une zone avec des pôles magnétiques nord et sud disposés en alternance le long d'une direction de déplacement, comprenant un montage en pont de Wheatstone avec une première branche de pont entre un premier raccord d'alimentation (5) et un premier raccord de sortie de signal (7) du montage en pont de Wheatstone, une deuxième branche de pont entre le premier raccord d'alimentation (5) et un deuxième raccord de sortie de signal (8) du montage en pont de Wheatstone, une troisième branche de pont entre un deuxième raccord d'alimentation (6) et le premier raccord de sortie de signal (7) du montage en pont de Wheatstone ainsi qu'une quatrième branche de pont entre le deuxième raccord d'alimentation (6) et le deuxième raccord de sortie de signal (8) du montage en pont de Wheatstone, dans lequel chacune des branches de pont comprend un élément de résistance ohmique avec une dépendance de la valeur de résistance par rapport à la force de champ magnétique d'un champ magnétique s'exerçant sur l'élément de résistance ohmique conformément à une courbe caractéristique prédéfinie, les valeurs de résistance de chacun des éléments de résistance ohmique variant dans le même sens en fonction de la force de champ magnétique du champ magnétique s'exerçant sur les éléments de résistance ohmique,
les courbes caractéristiques des éléments de résistance ohmique dans les première et la quatrième branches de pont (1, 4) étant choisies de façon à être au moins sensiblement analogues l'une à l'autre et nettement différentes des lignes caractéristiques des éléments de résistance ohmique dans les deuxième et la troisième branches de pont (2, 3), lesquelles sont choisies de façon à être au moins sensiblement analogues l'une à l'autre.

2. Capteur magnétorésistif selon la revendication 1,
les valeurs de résistance de chacun des éléments de résistance ohmique présentant la même valeur maximale.

3. Capteur magnétorésistif selon la revendication 1,
les valeurs de résistance des éléments de résistance dans les deuxième et troisième branches de pont (R2, R3) variant plus fortement en fonction de la force du champ que les valeurs de résistance des éléments de résistance dans les première et quatrième branches de pont (R1, R4).

4. Dispositif de mesure de déplacement et/ou de vitesse avec un codeur magnétique, lequel présente une zone avec des pôles magnétiques nord et sud disposés en alternance le long d'une direction de déplacement, **caractérisé par** un capteur magnétorésistif selon l'une des revendications 1 à 3.

5. Dispositif de mesure de déplacement et/ou de vitesse selon la revendication 4, **caractérisé par** un dispositif de calcul de fréquence, lequel est couplé à une entrée avec les raccords de sortie de signal du montage en pont de Wheatstone et émet un signal à une sortie, lequel forme une mesure pour la fréquence d'un signal émis par le capteur magnétorésistif.

FIG.1

FIG.2

FIG.3

FIG.4

11

FIG.5

FIG.6

FIG.7

FIG.8

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 0029815 A
- EP 0484859 A
- EP 0863406 A
- DE 10137294 A
- DE 3317594 A1
- DE OS2911733 A